Europäisches Patentamt

European Patent Office

Office européen des brevets

(19)

(11) Publication number: **0 180 101 B1**

# EUROPEAN PATENT SPECIFICATION

(12)

(45) Date of publication of patent specification: **27.12.91**

(51) Int. Cl.⁵: **H01L 21/48**, H05K 3/10, G03F 7/004

(21) Application number: **85113179.7**

(22) Date of filing: **17.10.85**

(54) Deposition of patterns using laser ablation.

(30) Priority: **01.11.84 US 667241**

(43) Date of publication of application:
**07.05.86 Bulletin 86/19**

(45) Publication of the grant of the patent:
**27.12.91 Bulletin 91/52**

(84) Designated Contracting States:
**DE FR GB**

(56) References cited:
**DE-A- 2 737 582**
**FR-A- 2 073 037**
**GB-A- 1 160 730**
**US-A- 4 414 059**

**IBM TECHNICAL DISCLOSURE BULLETIN, vol. 9, no. 11, April 1967, page 1474, New York, US; T.F. SAUNDERS et al.: "Metal plating of pyrolyzate circuitry"**

**34TH ELECTRONIC COMPONENTS CONFERENCE, New Orleans, Louisiana, 14th-16th May 1984, pages 82-87, IEEE; K. MORIYA et al.: "High density multilayer interconnection with photo-sensitive polymide dielectric and**

electroplating conductor"

(73) Proprietor: **International Business Machines Corporation**
**Old Orchard Road**
**Armonk, N.Y. 10504(US)**

(72) Inventor: **Baum, Thomas Hall**
**1103 Foxchase Drive**
**San Jose California 95123(US)**
Inventor: **Srinivasan, Rangaswamy**
**98 Cedar Lane**
**Ossining New York 10562(US)**

(74) Representative: **Atchley, Martin John Waldegrave**
**IBM United Kingdom Limited Intellectual Property Department Hursley Park**
**Winchester Hampshire SO21 2JN(GB)**

## Description

This invention relates to the deposition of patterns, such as conducting metal patterns, by an improved technique using a laser for ablation of a material containing constituents to be used in the deposition process.

Patterns of materials are often required in microelectronic structures, such as conducting metal patterns used in packaging and as current carrying lines in circuit designs. Many techniques are available for the deposition of fine linewidth patterns, including evaporation, sputtering and plating. These techniques generally use a mask to define the pattern to be deposited, where the mask is defined in a "wet" type of process wherein a liquid solvent is often used. In particular, electroless metal plating is used to deposit metallic patterns on substrates which are themselves nonconducting, such as silicon, ceramics, plastics, polymers such as PMMA, mylar (a trademark of E. I. duPont deNemours), etc. The provision of conducting metal lines on nonelectrically conducting substrates is of particular importance in microelectronic packaging, such as when copper lines are to be deposited on ceramic or polymer-type substrates.

As an example, copper has been electrolessly plated onto nonconducting substrates using a plurality of solutions during the plating process. Usually a sensitizing solution containing a tin sensitizer bath is used, followed by a wash in distilled water, and then the provision of a "seeding" layer containing palladium (Pd). The Pd seed layer is necessary for electroless plating of copper onto the substrate. After provision of the seed layer, the seeded sample is then placed in an appropriate copper plating solution for electroless plating of the copper layer. Plating will occur only in those regions of the substrate where the Pd seed layer is present.

The ability to deposit a metal for seeding is of great importance for packaging in the microelectronics field, and in other applications where electroless plating is required. Seeding enables the use of electroless plating baths for selective metal deposition, which in turn allows large and densely wired areas to be simultaneously processed. However, seed layers are not readily provided except by wet process steps as described above, which are more complicated and require a large number of process steps. In order to eliminate these problems, the present invention provides a "resist-type" of coating which can be sprayed or spun onto a substrate and then exposed in selected areas to ultraviolet light of a particular wavelength in order to expose seed metal particles located in the resist-type layer. In this manner, a patterned seed layer is provided in a dry processing step which eliminates the need for wet processing and other restrictions.

In the prior art, it is also known to use lasers and other energy beams for their heating effects in order to deposit conducting patterns such as metals. For example, reference is made to U. S. Patent 4,239,789, which describes the use of an energy beam to locally heat the surface of a substrate in order to promote plating from a plating solution in contact with the substrate. In this patent, visible or infrared wavelengths are used to provide the heating effect, which is an example of laser-enhanced plating.

Another reference generally dealing with the use of energy beams, such as laser beams, electron beams, or plasma arcs, to form a coating on a substrate, is U. S. Patent 4,400,408. In this patent, a metal surface is coated with an anticorrosive material and then is heated by an energy beam to form an alloy with the underlying substrate. As an alternative, the substrate can be coated with a solution of thermally decomposible metal compounds which are then decomposed to provide a material (Pt) that is freed for alloying with the substrate. This effect is also a thermal effect in which the presence of localized heat produces the desired reaction.

U. S. Patent 4,359,485 describes various techniques for laser induced photolysis of gas and liquid phases in order to decompose them for deposition onto a substrate. In this patent, a laser beam is absorbed by the surface onto which deposition is to occur, rather than being absorbed in the gas or liquid that is in contact with the substrate. Pulsed or continuous wave radiation of wavelengths 580-720 nm is generally used.

Another patent generally dealing with the use of laser radiation to deposit metals is U. S. Patent 4,451,503. In this patent, far UV wavelengths (e.g., 193 nm) are used to photodecompose metal or carbonyls in the vicinity of a substrate in order to deposit metals onto a substrate. Again, this is deposition from a gaseous phase, where the carbonyls absorb the far UV radiation and are thereby decomposed to release the species to be deposited on the substrate.

While the above-described references generally relate to the deposition of a material onto a substrate using an energy beam for decomposition of a material to yield a species to be deposited, U. S. Patent 3,935,117 describes the use of an energy beam to activate a photosensitive compound so that the compound can produce etching of an underlying substrate. In this reference, the photosensitive compound is dried to form a layer coating the surface to be etched, and is then irradiated. The function of the energy beam is merely to activate the solution so that etching will occur.

The use of far UV radiation for ablative photodecomposition (APD) is an effect which has been discovered by R. Srinivasan and which has been developed by him and other workers to provide many significant processing advantages. Some of the uses of far UV radiation include the deposition of metals (U. S. Patent 4,451,503), the photoetching of polyesters (U. S. Patent 4,417,948), the deposition of metals on polyester by irradiation of selected areas with far UV, followed by preplating treatment and then electroless plating (U. S. Patent 4,440,801), and dry photolithography in which resist-type materials are patterned by irradiation with far UV wavelengths (U. S. Patent 4,414,059).

In addition to the references described in the preceding paragraph the following references also describe the concept of ablative photodecomposition:

R. Srinivasan et al, Appl. Phys. Lett. (6), 576 (1982).

R. Srinivasan et al, J. Amer. Chem. Soc. 6784, (1982).

R. Srinivasan, J. Vac. Sci. Tech., 923 (1983).

Ablative photodecomposition is a process in which far ultraviolet radiation produces new effects in different materials. These materials absorb a very high percentage of incoming far UV radiation in a very thin surface layer of the material, where the absorption of the incoming radiation is confined to a very small volume of the material. This breaks long molecular chains of the material into small fragments, where the smaller fragments require a larger volume than the long molecular chains from which they are broken. Because a larger volume is required, the smaller fragments, which are volatile, explode or "ablate" from the surface of the irradiated material. When the fragments are blown away from the material, a localized etched region is left. Application of further pulses of far UV radiation will cause additional etching. In this manner, the material can be etched to any depth where the etching is essentially confined to the optical path of the radiation in the material.

For this effect, a threshold energy fluence must be exceeded in order for ablative photodecomposition to occur. Lasers, generally of the excimer-type, provide very useful sources of far UV radiation, since these lasers produce pulsed radiation of sufficient energy fluence per pulse to cause ablative photodecomposition. In particular, commercially available excimer lasers can be used to produce far UV radiation of sufficient energy fluence for ablative photodecomposition. Some of the commercially available lasers suitable for this purpose include the argon fluoride excimer laser (193 nm), the krypton fluoride excimer laser (248 nm), the Xenon chloride excimer laser (308 nm), and the Xenon fluoride excimer laser (351 nm).

Generally, the threshold energy fluence per pulse required for ablative photodecomposition increases as the wavelength increases. Thus, for a given material to be ablatively decomposed, the required energy fluence per pulse is greater for 351 nm radiation than for 193 nm radiation. However, the required optics are usually less complicated and costly for higher wavelength radiation. Thus, the optics required for radiation at 308 nm wavelengths is less complicated and less expensive than that required for 193 nm wavelength radiation. These considerations regarding the necessary optics and the types of available sources which can be used are well known to those of skill in the laser and optics technologies.

From the foregoing, it is apparent that it would be desireable to provide an improved technique for depositing patterns, especially conductive metal patterns, which would be a dry process and which would eliminate many of the presently required processing steps. Thus, it is an object of this invention to provide an improved process for depositing conductive metal patterns of fine linewidth, which is a dry process and in which the number of required steps is reduced.

In the prior art techniques for depositing conductive patterns on substrates which are nonconducting, a seeding layer has been required, the provision of which generally requires wet solutions and plating baths. In order to avoid this requirement, the present invention provides an improved technique for providing seeding layers for subsequent metal deposition processes, where the seeding layers are provided and patterned by dry processing.

In the further practice of the prior art, it has often been difficult to use air atmospheres and conventional projection photolithography, especially in those cases where laser-induced photolysis has been employed in the presence of liquid or vapor environments. Thus, it is another object of the present invention to provide an improved technique for deposition of patterns on all types of substrates, and especially nonconducting substrates, wherein vacuum environments are not required, and further wherein conventional projection photolithography can be used.

In packaging techniques, it is a requirement that large area exposures be accomplished at rapid rates and that fine line dimensions be provided. In the prior art, this has often been difficult due to the requirement for more complex vacuum environments and more costly projection systems, particularly where laser-induced deposition was used. Accordingly, it is another object of the present invention to provide an improved technique for the deposition of conductive patterns on substrates, and especially conductive metal patterns on nonelectrically conducting substrates, where the improved technique provides large area exposures at rapid rates and has the potential for providing patterns having fine line dimensions.

In the prior art, it has often been the situation that organic solvents have been required for wet processing of many resist-type polymers that are used as masking layers. While organic solvents can be employed in the present invention, it is a further object of this invention to provide a conductive seeding layer on a substrate which can be defined in a dry process, where the seeding layer includes a polymer binder which is soluble in water.

It is another object of the present invention to provide a process for depositing conducting patterns on substrates, including those which are nonconductive, where a seeding layer is provided and patterned in a dry process and in which large area exposure can be accomplished with conventional projection lithography in an air atmosphere.

It is another object of this invention to provide an improved technique for electrolessly plating conductive patterns on nonconductive substrates where a seed layer is required for the electroless plating, and in which the seed layer is provided from a coating which can be sprayed or spun onto the substrate rather than being plated thereon from a plating solution, and in which the seed coating is patterned by a dry processing step including the irradiation of the seed coating with light of far UV wavelengths.

## DISCLOSURE OF INVENTION

The present invention relates to a method for forming an electrically conductive layer on a substrate, comprising the steps of:
preparing a material capable of being applied as a resist-type layer onto the substrate, the material including seed constituents which can act as a seed layer for later formation of the electrically conductive layer, and the seed constituents being included in a polymer which will ablatively photodecompose at a greater rate than the seed constituents, applying the resist-type layer to the substrate, irradiating the resist-type layer with far UV radiation of wavelengths less than 400 nm and sufficient energy fluence to ablatively photo-decompose the resist-type layer to expose the seed constituents therein, thereby producing the seed layer, and forming the electrically conductive layer over the seed layer.

This invention relates to an improved technique for depositing patterns on substrates, and in particular, the formation of conductive metal patterns on insulating substrates, such as organic and inorganic substrates. The substrates include, for example, silica, ceramics, plastics, polymers, PMMA, mylar (a trademark of E.I. duPont deNemours), silicon, etc.

In a first step, a polymer is provided which includes therein a material which is to be a seed coating for the later deposition of a conductive pattern, such as a metal pattern. This seed-containing polymer is one which can be sprayed or spun onto the substrate, in a manner similar to the application of a resist-type material to a substrate. For example, a seed-containing polymer can be one including the metal palladium (Pd). The metal Pd is known to be a good seed layer for electroless plating of a copper layer. After application of the seed-containing layer, this layer is ablatively photodecomposed to expose the seed material. It has been found that the seed material will not be ablatively decomposed to the extent that the surrounding polymer will be ablatively photodecomposed. In the example of a seed-containing layer where Pd is the seed material, about 79% of the Pd content remained, while only approximately 17% of the carbon polymer remained after irradiation with far UV wavelengths. Thus, this process provides a seed layer which need not be plated from a solution, and which can be patterned by a dry processing step, (i.e., far UV irradiation).

After provision of the seed layer, electroless plating, or other techniques, can be used to provide the conductive pattern. Since the seed material is present only in those areas which have been irradiated by the far UV light, electroless deposition of a metal will occur only in those areas Thus, selective electroless deposition can be accomplished in the usual fashion, using well known plating baths.

The polymer containing the seed material is chosen to be one which can be applied in a manner similar to the application of a resist-type material; that is, it is a polymer which is easily spun or sprayed onto a substrate. The polymer is usually an organic material which can be ablatively photodecomposed by wavelengths less than 400 nm. The seed material is chosen to be effective as a seed for the later plating of a conductive pattern. The seed material will ablatively decompose at a much slower rate than the surrounding polymer so that a sufficient seed layer will be left after far UV irradiation.

In general, any source of far UV radiation of wavelengths less than 400 nm can be used, where the irradiation has sufficient power density to cause ablative photodecomposition. Generally, excimer lasers of a type well known in the art, and described hereinabove, can be used for this purpose, since they provide pulsed laser irradiation with sufficient energy fluence to ablatively photodecompose organic and inorganic polymers.

These and other objects, features, and advantages will be apparent from the following more particular description of the preferred embodiments.

BRIEF DESCRIPTION OF THE DRAWINGS

FIGS. 1-5 illustrate some of the major steps in the process for forming electrically continuous layers on a substrate. In particular, FIG. 1 illustrates the application of a seed layer to a substrate by a technique such as spinning or spraying, while FIG. 2 shows the seed layer applied to the substrate, where the seed layer contains seed constituents, such as metal, which can be used to later provide an electrically continuous layer thereover.

FIG. 3 illustrates ablative photodecomposition of selected areas of the seed layer in order to expose seed constituents therein, while FIG. 4 illustrates the resulting structure with the seed layer being altered in the exposed areas.

FIG. 5 shows the use of electroless plating to plate onto the exposed areas of the seed layer in order to provide an electrically continuous layer thereover.

BEST MODE FOR CARRYING OUT THE INVENTION

In the practice of this invention, a new technique is provided for producing seed layers on substrates, in order to make possible the later provision of electrically continuous patterns over the seed layer. Rather than using wet processing to produce a seed layer on a substrate, the present invention provides such a layer by ablatively photodecomposing a material which is cast (e.g., spun or sprayed) onto the substrate. This material contains the seed constituents which are exposed when the seed layer is irradiated by far UV light of sufficient energy fluence to ablatively photodecompose the material surrounding the seed constituents. After this, a final layer of electrically continuous material can be formed, as by electroless plating.

Referring now to the drawing, the major steps of the process are illustrated. The following description will describe this process generally, while more detailed examples will be given later.

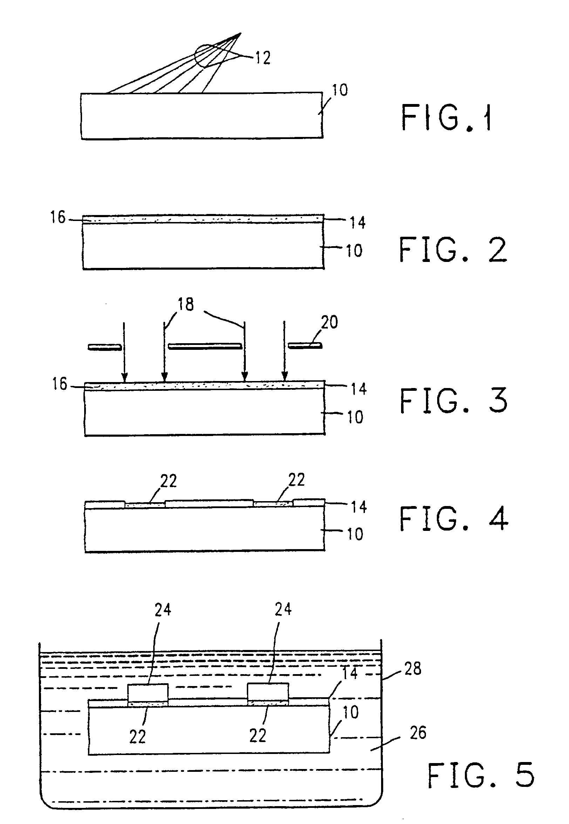

In FIG. 1, a substrate 10 is provided onto which is to, be applied a seed layer to be used for forming an electrically conducting layer. As an example, the seed layer is chosen to be a layer which will adhere well to the substrate 10 and which will provide materials that enable the subsequent electroless plating of an overlying layer of electrically continuous material, such as copper. Thus, FIG. 1 includes a plurality of arrows 12, illustrating the spinning or spraying of a material onto the substrate 10. This material is applied to the substrate 10 to produce a layer 14, as illustrated in FIG. 2. Layer 14 includes particles 16 therein, which are termed seed constituents. These seed constituents are the materials which are required for subsequent electroless plating of an overlying conductive layer. For example, particles 16 can be particles of a metal, such as Pd, if it is desired to electrolessly plate an overlying layer of copper.

Generally, the seed constituents are provided in a polymer-type binder which can be sprayed or spun onto the substrate 10 in the manner in which a resist-type material would be applied. In the practice of this invention, it is no longer necessary to provide a seed layer by the use of a wet plating bath, as had been done in the prior art. The layer 14 shown in FIG. 2 cannot be used in that form for electroless plating of an overlying metal layer. What is required is to sufficiently expose the seed constituents 16 in selected areas (or across the entire layer 14) in order to have sufficient amounts of the particulate 16 available for electroless plating. This is illustrated in FIG. 3, wherein far UV radiation is directed onto layer 14 through a mask 20.

The structure after irradiation is shown in FIG. 4. In this FIG., the irradiated regions 22 of layer 14 are slightly thinner than the remaining portions of layer 14, since the far UV radiation has ablatively photodecomposed layer 14 in these regions. This ablative photodecomposition removes more of the polymer binder of the layer than it does the seed constituents 16. This means that a heavy density of seed constituents is produced in the irradiated regions 22. This heavy density of seed constituents is adequate to provide an electroless plating base for the subsequent plating of an overlying electrically conductive layer.

FIG. 5 illustrates selective electroless plating of electrically conductive layer 24 on the seed layer regions 22. Electroless plating bath 26 is located in the plating chamber 28, and the structure shown in FIG. 4 is immersed in the plating bath 26. In a manner well known in the art, electroless plating will occur only on those regions of the substrate having the exposed seed layer 22.

As will be more clear later, the particulates 16 are provided as a dispersion in a polymer matrix of a type which can be applied by spraying or spinning onto the substrate 10. Generally, the polymer is an organic material comprised of long molecular chains which can be fragmented by the applied far UV radiation, as explained in the previously cited references describing ablative photodecomposition. The seed constituents are any materials which, when exposed to the electroless plating solution, can be used to promote plating of the overlying electrically conductive layer.

The ablative photodecomposition step wherein the layer 14 is selectively decomposed to expose the seed constituent 16, as illustrated in FIG. 3, can be accomplished with any type of far UV source capable of providing radiation of wavelengths less than 400 nm and sufficient power density (energy fluence) to cause ablative photodecomposition. The various types of excimer lasers described previously can be used in the practice of this invention. These lasers provide proper wavelength outputs and pulsed radiation of sufficient energy fluence to produce ablative photodecomposition.

Typically, the layer 14 is a metallized polymer system of a type well known in the art. For example, such metallized polymer systems have been described by J. Patschorke, Adhesion, 273 (1972). In addition to this reference, the following references describe, respectively, polymers containing metal ions for conducting polymers, solar-energy conversion, and photo sensitive coatings.

E. W. Neuse et al, Macromolecules, 187 (1979).

M. S. Wrighton, Ed. "Interfacial Photo Processes, Energy Conversion and Synthesis", Advances in Chemistry Series, 184 (1980).

B. Duncalf et al, J. Appl. Polym. Sci., 1763 (1964).

Additionally, Cu (II) containing poly (vinyl alcohol) polymers are known and readily synthesized, as can be seen by referring to K. Kamura et al, Die Makromolekulare Chemie, 225 (1975). Similar polymer systems can be achieved with the incorporation of other metal ions. In particular, an example will be presented of a polymer and its synthesis where the polymer is a Pd (II)/poly (vinyl alcohol) polymer which is used to aid the deposition of conducting metal lines by electroless copper plating. This ability to deposit a metal for seeding is of great importance in packaging techniques used in the microelectronics field. Seeding enables the utilization of electroless plating baths for selective metal deposition, which in turn allows large and dense wide areas to be simultaneously processed.

EXAMPLE

Electroless plating of copper onto a seed layer containing Pd has been accomplished. A polymer layer comprised of Pd/poly (vinyl alcohol) was synthesized, which can be done by several techniques. The most facile procedure was based on using commercial (Aldrich Company) poly (vinyl alcohol) (PVA) of M = 86,000, which was dissolved in distilled water. The pH of the stirred solution was adjusted to 8-9 by the addition of sodium bicarbonate. To this solution, Pd Cl$_2$ was added and the reaction mixture stirred for two hours. Control of the pH of the solution is important to the formation of the palladium/PVA complex. The gray-colored polymer was recovered by vacuum filtration.

The isolated Pd/PVA polymer was redissolved in distilled water by heating to 80-90° C. with vigorous stirring. The polymer solution was vacuum filtered through filters of decreasing pore size. The vinyl material was free of large particles and could be spun into smooth film on a lithographic spinner. Thin films were prepared using a 10% solution of the Pd/PVA polymer at a spin rate of 5,000 rpm for 40 seconds (all substrates were cleaned prior to use). Microprobe analysis of a film prepared in this manner gave a calculated thickness of 226 x $10^{-10}$m ( 226 angstroms), based upon carbon content and density. The same analysis indicated that the polymer contained 23.9% Pd by weight per unit area of the film. It was found that more concentrated solutions lead to thicker films.

The Pd/PVA film was then irradiated with far UV light in order to ablatively photodecompose it. In one example, the irradiation was performed with a Lambda Physik EMG. 50 excimer laser using an ArF gas mixture. The output wavelength was 193 nm, and typical powers used were from 45-75 mJ/pulse. The pulse repetition rate was 8 Hz. The rectangular beam (pulse width = 14 ns) covered a 3.0 cm$^2$ area and the average total dose of the incident pulse was 1.14 x $10^7$ watts/cm$^2$. The beam was focussed into a line by using a Suprasil cylindrical lens having a 200 nm focal length. The incident laser radiation was monitored, prior to focussing through the lens, with a GenTec Joulemeter. Due to the non-uniformity of the incident beam, the power density of the focussed line may vary by 10-20% across the line. Irradiation of the films was carried out by placing a metal mask in contact with the substrate. The sample is moved through the focussed laser beam by the use of a stepper motor stage. In this manner, several repetitive scans were easily carried out.

The use of electron beam x-ray microprobe analysis allowed the comparison of the carbon and palladium content before and after laser exposure. This provided an analysis in which 69% of the palladium content remained, while only 17% of the carbon remained after laser exposure. This indicated that the carbon backbone of the polymer was ablated at a higher rate than the palladium content. The enhanced ablation of the carbon species versus the palladium species allows seeding to occur. The high vapor pressure of the small carbon fragments relative to palladium could account for the observed ablation disparity.

After laser exposure, the samples were processed using commercially available electroless plating baths: Enplate Sn 432 sensitizer and Enplate copper plating solutions were freshly prepared prior to use. This technique allowed skipping the Enplate Pd 440 activator.

In a typical procedure, the laser exposed sample was dipped in the Sn sensitizer bath for 45 seconds, followed by a 30 second wash in distilled water. The sample was then placed into the copper plating bath. After 2-10 minutes in the copper plating solution, the sample was removed, washed with water and blown dry with an air gun. Copper metal had been selectively deposited in the areas that were exposed to the laser radiation, i.e., on those areas where the seed constituents (Pd) were exposed. These copper films were continuous and conducting. Greater thicknesses of the copper deposit were achieved with prolonged exposure to the copper plating bath. Several control experiments were performed:
(a) the non-exposed Pd/PVA films were put through the normal cycle used for the plating procedure. No copper deposition was observed; (b) films of Pd/PVA were exposed to the laser radiation (193 nm) and processed. Elimination of the Sn sensitizer bath in copper plating procedure failed to induce copper deposition in the irradiated areas; (c) films of PVA (no Pd) were irradiated with 193 nm light and processed for copper deposition in the same manner as previously described. No copper deposition was observed.

Infrared spectra of thin films of the Pd/PVA polymer were run on an infrared spectrometer. Characteristic metal-to-oxygen stretching bands were observed at 480 and 605 cm$^{-1}$, and are indicative of the Pd-oxygen bond. The infrared absorption at 605 (CuO stretch) was observed for the Cu/PVA system as pointed out in the above described Kimura et al reference. Infrared absorptions at 480 cm$^{-1}$ have been observed in platinum complexes containing metal-oxygen bonding, as noted by G. W. Bushnell et al, Can. J. Cagm., 3694 (1973).

While examples using silicon wafer substrates have been described, this same process can be utilized on organic substrates such as, mylar (a trademark of DuPont Company), and PNMA. The major problem associated with this process on polymers is simply the adhesion of Pd/PVA to the organic substrates. The use of an adhesion promoter did not markedly enhance the adhesion of the Pd/PVA material.

DISCUSSION OF EXPERIMENTAL RESULTS

The content of the Pd metal directly affects the plating process, an increase in Pd content being marked by an improved plating rate. Also, Pd metal is the necessary component (catalyst) for electroless copper plating.

The fact that the exposed regions of the polymer induce plating in the copper deposition baths is direct evidence that some Pd species remained. Microprobe analysis also supports this. Although the oxidation state of Pd (in the exposed regions) could not be determined by this analysis, the fact that the copper deposition does not occur without the use of the Sn sensitizer bath indicates that the Pd metal is in a plus 2 oxidation state. It is known that Sn(II) is oxidized to the Sn(IV) state while reducing Pd (II) to Pd (0) in some common, present day seeding systems. The state of the remaining Pd can only be inferred from the control experiment to indicate an oxidation state of plus 2.

The fact that the Pd/PVA polymer does not induce copper deposition (upon identical processing) without laser irradiation indicates that the Pd species is chemically bound to the PVA polymer through the oxygen moiety. This bonding does not enable the Pd to be reduced in the Sn bath, thereby indicating a stable Pd/PVA chelate structure. The infrared spectrum for this system also indicates true covalent bonding of Pd to oxygen, with the presence of Pd/0 stretches at 605 and 480 cm$^{-1}$. The chemical structure of the chelated Pd/PVA polymer may be viewed as the following:

This structure has also been postulated for copper containing PVA polymers by V. W. Kuhn and I. Toth in Z. Naturforsch, 112 (1963).

SEM examination of both irradiated and non-irradiated films of the Pd/PVA system indicate a finely dispersed, Pd ridge area after laser exposure. Examination of a copper line (deposited by electroless deposition) by SEM showed a smooth, continuous film of uniform morphology. The deposited copper showed good definition on the edge of the line, that was exposed through a contact mask. The edge definition and resolution of the exposed areas are determined by the mask that is used, and thus, determine the resolution/definition of the copper deposited by this method.

As mentioned previously, the Pd/PVA polymer is quite sensitive to pH. The polymer is formed in basic, aqueous solutions and was observed to decompose upon treatment with acidic, aqueous solutions. Due to the fact that the Sn sensitizer bath is acidic, the non-exposed polymer was dissolved in this bath. However, a quick rinse in acidic solution, prior to treatment with the Sn bath, allowed removal of the unexposed polymer, thus avoiding contamination of the Sn bath.

The Pd/PVA polymer was also observed to be thermally reactive. When thin films of the polymer were heated on a plate, a substantial degree of crosslinking occurred. This rendered the polymer insoluble in water. This type of thermal reaction may be similar to the crosslinking that has been observed for the Cr/PVA polymer systems, as described by B. Duncalf et al, cited above.

The loading of Pd into the PVA polymer during synthesis can be altered by varying the concentration of the reactants. It is not clear whether a greater weight percent of Pd would have any effect on the ablative photodecomposition of the polymer system, but it may cause an enhancement of the electroless plating of copper.

These examples illustrate the use of seed constituent containing polymers for electroless plating of metals. These polymers are often aqueous solutions which do not require organic solvents and which can be easily cast onto substrates.

In the practice of this invention, it will be appreciated that the polymer can contain metals other than Pd. For example, such metals may include the following: Pt, Au, and Sn.

Additionally, the provision of a metal "seeding" layer in this way can be used as a seed layer for techniques other than electroless heating. Still further, while copper plating is an important example in packaging of microelectronic components, other metals can also be electrolessly plated over a seed layer provided in this fashion. Such other metals include, for examples Ni, Ag, and Au.

## Claims

1. A method for forming an electrically conductive layer on a substrate, comprising the steps of:

   preparing a material capable of being applied as a resist-type layer onto said substrate, said material including seed constituents which can act as a seed layer for later formation of said electrically conductive layer, and said seed constituents being included in a polymer which will ablatively photo-decompose at a greater rate than said seed constituents,

   applying said resist-type layer to said substrate,

   irradiating said resist-type layer with far UV radiation of wavelengths less than 400 nm and sufficient energy fluence to ablatively photo-decompose said resist-type layer to expose said seed constituents therein, thereby producing said seed layer, and

   forming said electrically conductive layer over said seed layer.

2. The method of claim 1, where said resist-type layer is irradiated in selected areas thereof.

3. The method of claim 2, where said electrically conductive layer is formed by electroplating onto said exposed seed constituents.

4. The method of claim 3, where said electrically conductive layer is copper.

5. The method of claim 3, where said electrically conductive layer is copper and said seed constituents are palladium.

6. The method of any one of the preceding claims, where said resist-type layer is comprised of metal particles in a polymer.

7. The method of any one of the preceding claims, where said resist-type layer is applied to said substrate by spinning or spraying it on to said substrate.

8. The method of any one of the preceding claims, in which said resist-type layer has a thickness of less than $5 \times 10^{-8}$ m.

9. The method of any one of the preceding claims, where said substrate is electrically insulating.

10. The method of any one of the preceding claims, where said substrate is selected from the group consisting of silica, ceramics, inorganic polymers, organic polymers, and resist-type polymers.

## Revendications

1. Procédé pour former une couche conductrice électriquement sur un substrat, comprenant les étapes suivantes:

   préparation d'un matériau capable d'être appliqué en tant que couche de type réserve sur ce substrat, ce matériau comprenant des constituants d'ensemencement qui peuvent jouer le rôle de couche d'ensemencement pour la formation ultérieure de cette couche conductrice électriquement, et ces constituants d'ensemencement étant inclus dans un polymère qui va subir une photodécomposition avec ablation à une vitesse supérieure à celle de ces constituants d'ensemencement,

application de cette couche de type réserve sur ce substrat,

irradiation de cette couche de type réserve avec un rayonnement UV lointain de longueurs d'onde inférieures à 400 nm et avec un flux d'énergie suffisant pour photodécomposer avec ablation cette couche de type réserve de façon à exposer ces constituants d'ensemencement qui se trouvent dans celle-ci, et

formation de cette conductrice électriquement sur cette couche d'ensemencement.

2. Procédé suivant la revendication 1, dans lequel cette couche de type réserve est irradiée dans des zones sélectionnées de celle-ci.

3. Procédé suivant la revendication 2, dans lequel cette couche conductrice électriquement est formée par dépôt électrolytique sur ces constituants d'ensemencement exposés.

4. Procédé suivant la revendication 3, dans lequel cette couche conductrice électriquement est du cuivre.

5. Procédé suivant la revendication 3, dans lequel cette couche conductrice électriquement est du cuivre et ces constituants d'ensemencement sont du palladium.

6. Procède suivant l'une quelconque des revendications précédentes, dans lequel cette couche de type réserve est composée de particules métalliques dans un polymère.

7. Procédé suivant l'une quelconque des revendications précédentes, dans lequel cette couche de type réserve est déposée sur ce substrat par centrifugation ou pulvérisation de celle-ci sur ce substrat.

8. Procédé suivant l'une quelconque des revendications précédentes, dans lequel cette couche de type réserve a une épaisseur inférieure à $5 \times 10^{-8}$ m.

9. Procédé suivant l'une quelconque des revendications précédentes, dans lequel ce substrat est isolant électriquement,

10. Procédé suivant l'une quelconque des revendications précédentes, dans lequel ce substrat est choisi dans le groupe consistant en silice, céramiques, polymères inorganiques, polymères organiques et polymères de type réserve.

**Patentansprüche**

1. Verfahren zum Ausbilden einer elektrisch leitenden Schicht auf einem Substrat, welches die folgenden Schritte umfaßt:

Präperieren eines Materials, das als eine resistartige Schicht auf das Substrat aufgebracht werden kann, wobei das Material Saatkomponenten aufweist, die wie eine Saatschicht zum späteren Ausbilden der elektrisch leitenden Schicht wirken können, und die Saatkomponenten in einen Polymer eingeschlossen sind, das sich ablativ bei einer größeren Rate als die Saatkomponenten mittels Licht zersetzen wird

Aufbringen der resistartigen Schicht auf das Substrat,

Bestrahlen der resistartigen Schicht mit ferner UV-Strahlung mit Wellenlängen, die kleiner als 400 nm sind und mit einer hinreichenden Energiefluenz, um die resistartige Schicht ablativ, mittels Licht zu zersetzen, um die Saatkomponenten darin freizulegen, wodurch die Saatschicht erzeugt wird und

Ausbilden der elektrisch leitenden Schicht über der Saatschicht

2. Verfahren nach Anspruch 1, bei welchem die resistartige Schicht in ausgewählten Bereichen bestrahlt wird.

3. Verfahren nach Anspruch 2, bei welchem die elektrisch leitende Schicht durch Elektroplattieren aus den freigelegten Saatkomponenten ausgebildet wird.

4. Verfahren nach Anspruch 3, bei welchem die elektrisch leitende Schicht Kupfer ist.

5. Verfahren nach Anspruch 3, bei welchem die elektrisch leitende Schicht Kupfer ist und die Saatkomponenten Palladium sind.

6. Verfahren nach irgend einem der vorhergehenden Ansprüche, bei welchem die resistartige Schicht aus Metallteilchen in einem Polymer besteht.

7. Verfahren nach irgend einem der vorhergehenden Ansprüche, bei welchem die resistartige Schicht durch Zentrifugieren oder Aufsprühen auf das Substrat aufgebracht wird.

8. Verfahren nach irgend einem der vorhergehenden Ansprüche, bei welchem die resistartige Schicht eine Dicke von weniger als $5 . 10^{-8}$ m besitzt.

9. Verfahren nach irgend einem der vorhergehenden Ansprüche, bei welchem das Substrat elektrisch isolierend ist.

10. Verfahren nach irgend einem der vorhergehenden Ansprüche, bei welchem das Substrat aus der Gruppe ausgewählt wird, die Silika, Keramik, anorganische Polymere, organische Polymere und resistartige Polymere umfaßt.

FIG.1

FIG. 2

FIG. 3

FIG. 4

FIG. 5